# EUROPEAN PATENT APPLICATION

(11) **EP 1 174 911 A2**
(43) Date of publication of application: **23.01.2002**
(21) Application number: 01113399.8
(22) Date of filing: 01.06.2001
(51) Int. Cl.: H01L 21/027, H01L 21/768

(54) **Silicon nitride as anti-reflective coating**

(30) Priority: 05.06.2000 US 587355
(71) Applicant: Applied Materials, Inc., Santa Clara, California 95054 (US)
(72) Inventor: Feng, Joe, Cupertino, California 95014 (US); Patel, Anjana M., San Jose, California 95138 (US); Shek, Mei Yee, Burlingame, California 94010 (US); Huang, Judy H., Los Gatos, California 95032 (US); Ngai, Christopher S., Burlingame, California 94010 (US)
(74) Representative: Kirschner, Klaus Dieter, Dipl.-Phys.

(57) **Abstract**

A method of forming an integrated circuit using a silicon nitride anti-reflective coating (ARC) is disclosed. The silicon nitride layer is formed by reacting a silicon-containing compound with a nitrogen-containing compound. The silicon nitride layer is compatible with integrated circuit fabrication processes. In one integrated circuit fabrication process, the silicon nitride ARC is used as a hardmask. In another integrated circuit fabrication process, the silicon nitride ARC is incorporated into a damascene structure.

## Description

The invention relates generally to anti-reflective coatings (ARCs). More particularly, the invention relates to anti-reflective coatings useful at deep ultraviolet (DUV) wavelengths.

Integrated circuits have evolved into complex devices that can include millions of transistors, capacitors and resistors on a single chip. The evolution of chip designs continually requires faster circuitry and greater circuit density. The demands for faster circuits with greater circuit densities impose corresponding demands on the process sequences used for integrated circuit manufacture.

In particular, the demands for greater circuit densities on integrated circuits have necessitated smaller pattern dimensions (e. g., sub-micron dimensions). As the pattern dimensions are reduced, lithographic imaging tools having deep ultraviolet (DUV) imaging wavelengths (e. g., wavelengths less than 250 nanometers (nm)) are used to generate photoresist patterns. The DUV imaging wavelengths are desirable because diffraction effects (e. g., beam spreading) are reduced at these shorter wavelengths, improving the resolution of photoresist patterns formed therewith. However, many underlying materials (e. g., polysilicon, metals, and metal silicides) can reflect light at DUV wavelengths. Such reflected light can destructively interfere with the incident imaging wavelengths, creating linewidth variations in the resulting photoresist patterns.

One technique proposed to minimize reflections from underlying material layers uses an anti-reflective coating (ARC). The ARC is formed over the reflective material layer prior to resist patterning. The ARC suppresses the reflections off the underlying material layer during photoresist imaging, providing accurate pattern replication in the layer of photoresist.

A number of materials have been suggested as ARCs for use in combination with photoresist materials such as, for example, titanium nitride. However, titanium nitride is increasingly reflective as the imaging wavelength is reduced below 248 nm, meaning titanium nitride has high reflectivity for DUV radiation and is not an effective anti-reflective coating for DUV wavelengths.

Another material suggested as an ARC for use with photoresist materials is silicon oxynitride. However, silicon oxynitride films are difficult to remove from integrated circuit substrates and tend to leave residues behind that potentially interfere with subsequent integrated circuit fabrication steps.

Therefore, a need exists in the art for a material layer useful for integrated circuit fabrication, which is an ARC at DUV wavelengths.

The present invention generally provides a method of fabricating an integrated circuit (IC) using a silicon nitride anti-reflective coating (ARC). The silicon nitride ARC is formed on a substrate from a reaction of a gas mixture comprising a silicon containing compound and a nitrogen-containing compound. The gas mixture, which may optionally include an additive gas, is introduced into a process chamber where the reaction of the silicon containing compound with the nitrogen-containing compound in close proximity to the substrate results in the deposition of a silicon nitride layer on the substrate surface.

The silicon nitride layer is compatible with various integrated circuit fabrication processes. In one integrated circuit fabrication process, the silicon nitride layer is used as an anti-reflective coating (ARC) for DUV lithography. For such an embodiment, a preferred process sequence includes forming the silicon nitride layer on a substrate. The silicon nitride layer has a refractive index (n) in the range of about 2.0 to about 2.7 and an absorption coefficient (k) in the range of about 0.05 to about 1.0 at wavelengths less than about 250 nm. The refractive index and the absorption coefficient of the silicon nitride layer are tunable, in that they can be varied in the desired range as a function of the process parameters used during layer formation. After the silicon nitride layer is formed on the substrate, a layer of energy sensitive resist material is formed thereon. A pattern is defined in the energy sensitive resist at a wavelength less than about 250 nm. Thereafter, the pattern defined in the energy sensitive resist is transferred into the silicon nitride layer. After the silicon nitride layer is patterned, such pattern is optionally transferred into the substrate using the silicon nitride layer as a hardmask.

In another integrated circuit fabrication process, the silicon nitride layer is incorporated into a damascene structure. For such an embodiment, a preferred process sequence includes depositing a first dielectric layer on a substrate. A silicon nitride layer is then formed on the first dielectric layer. Thereafter, the silicon nitride layer is patterned and etched to define contacts/vias therethrough. After the silicon nitride layer is patterned and etched, a second dielectric layer is deposited thereover. The second dielectric layer is than patterned and etched to define interconnects therethrough. The interconnects formed in the second dielectric layer are positioned over the contacts/vias formed in the silicon nitride layer. After the interconnects are formed, the contacts/vias defined in the silicon nitride layer are etched through the first dielectric layer to the substrate surface. Thereafter, the damascene structure is completed by filling the interconnects and contacts/vias with a conductive material.

The teachings of the present invention can be readily understood by considering the following detailed description in conjunction with the accompanying drawings, in which:
FIG. 1 depicts a schematic illustration of an apparatus that can be used for the practice of this invention;
FIGS. 2a-2e depict schematic cross-sectional views of a substrate structure at different stages of integrated circuit fabrication incorporating a silicon nitride layer as an anti-reflective coating (ARC) for deep ultraviolet (DUV) wavelengths; and
FIGS. 3a-3d depict schematic cross-sectional views of a damascene structure at different stages of integrated circuit fabrication incorporating a silicon nitride layer in such structure.

The present invention provides a method of forming an integrated circuit using a silicon nitride anti-reflective coating (ARC). The silicon nitride ARC is formed on a substrate from a reaction of a gas mixture comprising a silicon containing compound and a nitrogen-containing compound. The gas mixture, which may optionally include an additive gas, is introduced into a process chamber where the reaction of the silicon containing compound with the nitrogen-containing compound in close proximity to the substrate, results in the deposition of a silicon nitride layer on the substrate surface. The silicon nitride layer is compatible with various integrated circuit fabrication processes, examples of which are discussed below.

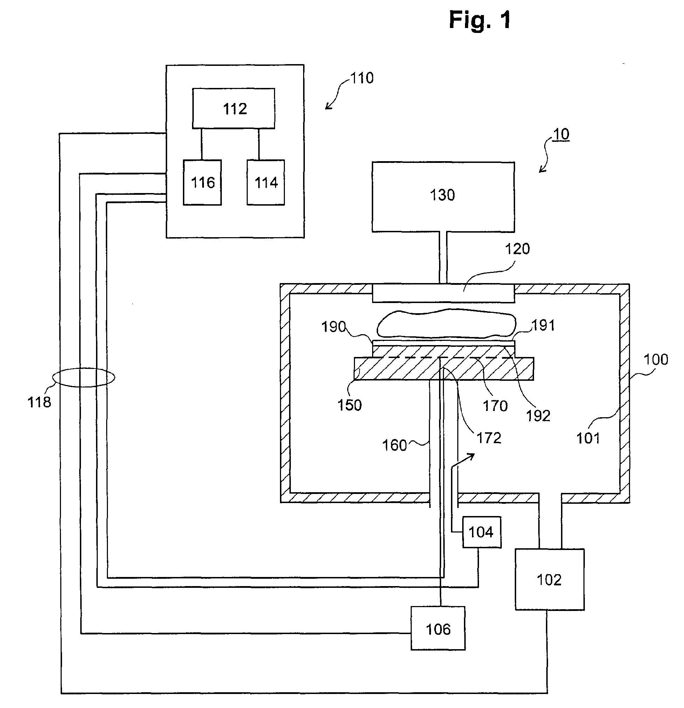

FIG. 1 is a schematic representation of a wafer processing system 10 that can be used to perform silicon nitride layer formation in accordance with the present invention. This apparatus typically comprises a process chamber 100, a gas panel 130, a control unit 110, along with other hardware components such as power supplies and vacuum pumps. Examples of suitable deposition chambers include PRODUCER™ chambers, DXZ™ chambers, and ULTIMA™ chambers, commercially available from Applied Materials, Inc., Santa Clara, California.

Details of the system 10 used in the present invention are described in commonly assigned U. S. patent application Serial No. 09/211,998, entitled "High Temperature Chemical Vapor Deposition Chamber", filed on December 14, 1998, and is hereby incorporated by reference. The salient features of this system 10 are briefly described below.

The process chamber 100 generally houses a support pedestal 150, which is used to support a substrate such as a semiconductor wafer 190. This pedestal 150 can typically be moved in a vertical direction inside the chamber 100 using a displacement mechanism (not shown). Depending on the specific process, the wafer 190 can be heated to some desired temperature prior to layer deposition. For example, the wafer support pedestal 150 is heated by an embedded heater element 170. The pedestal may be resistively heated by applying an electric current from an AC power supply 106 to the heater element 170. The wafer 190 is, in turn, heated by the pedestal 150. A temperature sensor 172, such as a thermocouple, is also embedded in the wafer support pedestal 150 to monitor the temperature of the pedestal 150 in a conventional manner. The measured temperature is used in a feedback loop to control the AC power supply 106 for the heating element 170, such that the wafer temperature can be maintained or controlled at a desired temperature which is suitable for the particular process application. The pedestal 150 is optionally heated using radiant heat (not shown).

A vacuum pump 102, is used to evacuate the process chamber 100 and to maintain the proper gas flows and pressure inside the chamber 100. A showerhead 120, through which process gases are introduced into the chamber 100, is located above the wafer support pedestal 150. The showerhead 120 is connected to a gas panel 130, which controls and supplies various gases used in different steps of the process sequence.

The showerhead 120 and wafer support pedestal 150 also form a pair of spaced apart electrodes. When an electric field is generated between these electrodes, the process gases introduced into the chamber 100 are ignited into a plasma. Typically, the electric field is generated by connecting the wafer support pedestal 150 to a source of radio frequency (RF) power (not shown) through a matching network (not shown). Alternatively, the RF power source and matching network may be coupled to the showerhead 120, or coupled to both the showerhead 120 and the wafer support pedestal 150.

Plasma enhanced chemical vapor deposition (PECVD) techniques promote excitation and/or disassociation of the reactant gases by the application of the electric field to the reaction zone near the substrate surface, creating a plasma of reactive species. The reactivity of the species in the plasma reduces the energy required for a chemical reaction to take place, in effect lowering the required temperature for such PECVD processes.

In at least one embodiment, silicon nitride (Si₂N₃) layer deposition is accomplished by plasma enhanced reaction of a silicon-containing compound with a nitrogen-containing compound. Both the silicon containing compound and the nitrogen containing compound are introduced into the process chamber 100 under the control of gas panel 130 as gases with regulated flows.

Proper control and regulation of the gas flows through the gas panel 130 is performed by mass flow controllers (not shown) and a controller unit 110 such as a computer (not shown). The showerhead 120 allows process gases from the gas panel 130 to be uniformly introduced and distributed in the process chamber 100. Illustratively, the control unit 110 comprises a central processing unit (CPU) 113, support circuitry 114, and memories containing associated control software 116. This control unit is responsible for automated control of the numerous steps required for wafer processing, examples of which include wafer transport, gas flow control, temperature control, and chamber evacuation. Bi-directional communications between the control unit 110 and the various components of the apparatus 10 are handled through numerous signal cables collectively referred to as signal buses 118, some of which are illustrated in FIG. 1.

The heated pedestal 150 is typically made of aluminum, and comprises a heating element 170 embedded at a distance below the wafer support surface 151 of the pedestal 150. The heating element 170 can be made of a nickel-chromium wire encapsulated in an Incaloy sheath tube. By properly adjusting the current supplied to the heating element 170, the wafer 190 and the pedestal 150 can be maintained at a relatively constant temperature during film deposition. This is accomplished by a feedback control loop, in which the temperature of the pedestal 150 is continuously monitored by a thermocouple 172 embedded in the pedestal 150. This information is transmitted to the control unit 110, via a signal bus 118, which responds by sending the necessary signals to the heater power supply. Adjustment is subsequently made in the current supply 106 to maintain and control pedestal 150 at a desirable temperature (i. e., a temperature that is appropriate for the specific process application). When the process gas mixture exits the showerhead 120, plasma enhanced reaction of the silicon containing compound with the nitrogen containing compound occurs at the surface 191 of the heated wafer 190, resulting in the deposition of a silicon nitride layer on the wafer 190.

### Silicon Nitride Layer Formation

In one embodiment, the silicon nitride layer is formed from a gas mixture of a silicon containing compound and a nitrogen-containing compound. The silicon-containing compound has the general formula SiₓH_{y}, where x has a range between 1 and 4, and y has a range between 1 and 10. For example, silane (SiH₄), disilane (Si₂H₆), trisilane (Si₃H₈), tetrasilane (Si₄H₁₀), as well as combinations thereof, may be used for the silicon-containing compound. Also, silane derivatives such as dichlorosilane (SiCl₂H₂) may be used for the silicon-containing compound.

The nitrogen-containing compound may include ammonia (NH₃) and nitrogen (N₂), as well as combinations thereof. Additionally, a variety of carrier gases such as nitrogen (N₂), argon (Ar), helium (He), or combinations thereof, among others, may also be added to the gas mixture.

In general, the following deposition process parameters can be used to form the silicon nitride layer. The process parameters range from a wafer temperature of about 200 °C to about 600 °C, a chamber pressure of about 1 torr to about 20 torr, a silicon containing compound gas flow rate of about 50 sccm to about 500 sccm, a nitrogen containing compound gas flow rate of about 10 sccm to about 300 sccm, a carrier gas flow rate of about 1000 sccm to about 5000 sccm, a radio frequency power of between about 100 Watts to about 1000 Watts, and an electrode spacing of between about 300 mils to about 800 mils. The above process parameters provide a deposition rate for the silicon nitride layer in the range of about 1000 Å/min to about 10,000 Å/min, when implemented on a 200 mm (millimeter) substrate in a deposition chamber available from Applied Materials, Inc.

Other deposition chambers are within the scope of the invention, and the parameters listed above may vary according to the particular deposition chamber used to form the silicon nitride layer. For example, other deposition chambers may have a larger (i. e., configured to accommodate 300 mm substrates) or smaller volume, requiring gas flow rates that are larger or smaller than those recited for deposition chambers available from Applied Materials, Inc.

The as-deposited silicon nitride layer has a light absorption coefficient (k) that can be varied between about 0.05 to about 1.0, as well as a refractive index that can be varied between about 2.0 and 2.7 at wavelengths below about 250 nm, making it suitable for use as an anti-reflective coating at DUV wavelengths. Both the absorption coefficient and the refractive index are variable as a function of the silicon content in the layer. In particular, as the silicon content increases both the absorption coefficient and the refractive index of the as-deposited layer also increase.

The absorption coefficient and the refractive index of the silicon nitride layer can also be varied as a function of the process parameters used during layer formation. For example, as the chamber pressure increases, both the absorption coefficient and the refractive index of the as-deposited silicon nitride layer decrease. Also, as the electrode spacing decreases, both the absorption coefficient and the refractive index increase.

### Integrated Circuit Fabrication Processes

### A. Silicon Nitride Anti-Reflective Coating (ARC)

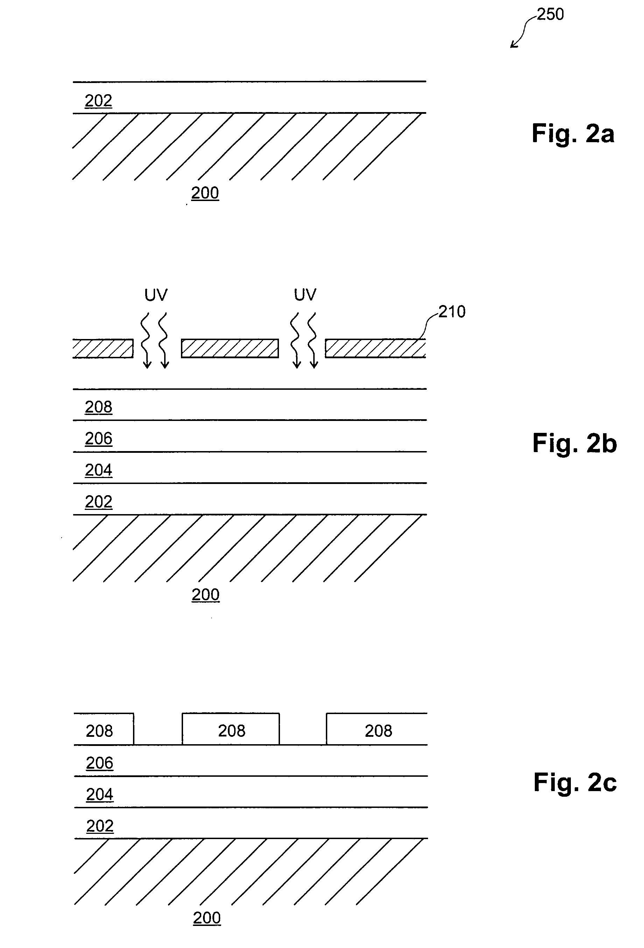

FIGS. 2a-2e illustrate schematic cross-sectional views of a substrate 200 at different stages of an integrated circuit fabrication sequence incorporating a silicon nitride layer as an anti-reflective coating (ARC) for DUV wavelengths. In general, the substrate 200 refers to any workpiece on which film processing is performed, and a substrate structure 250 is used to generally denote the substrate 200 together with other material layers formed on the substrate 200. Depending on the specific stage of processing, substrate 200 may correspond to a silicon substrate or other material layer, which has been formed on the substrate. FIG. 2a, for example, illustrates a cross-sectional view of a substrate structure 250, having a material layer 202 that has been conventionally formed thereon. The material layer 202 may be a metal (e.g., aluminum). In general, the substrate structure 250 may include a layer of silicon, silicides, oxides, or other material. FIG. 2a illustrates one embodiment in which the substrate 200 is silicon having a polysilicon layer formed thereon.

FIG. 2b depicts a silicon nitride layer 204 formed on the substrate structure 250 of FIG. 2a. The silicon nitride layer 204 is formed on material layer 202 according to the process parameters described above. The silicon nitride layer has a refractive index (n) in the range of about 2.0 to about 2.7 and an absorption coefficient (k) in the range of about 0.05 to about 1.0 at wavelengths less than about 250 nm. The refractive index (n) and the absorption coefficient (k) for the silicon nitride layer are tunable, in that they can be varied in the desired range as a function of the process parameters and/or the silicon content of the gas mixture during layer formation.

The thickness of the silicon nitride layer is variable depending on the specific stage of processing. Typically, the silicon nitride layer is deposited to a thickness of about 50 Å to about 5000 Å.

A layer of energy sensitive resist material 208 is formed on the silicon nitride layer 204. The layer of energy sensitive resist material 208 can be spin coated on the substrate structure 250 to a thickness within the range of about 4000 Å to about 7000 Å. The energy sensitive resist material is sensitive to DUV radiation having a wavelength less than about 250 nm.

Depending on the type of energy sensitive resist material used in the fabrication sequence, an intermediate layer 206 is formed on the silicon nitride layer 204. Some energy sensitive resist materials (e. g., Shipley UV5 deep UV resist, JSR M20G deep UV resist) react with moisture to form amino basic groups (NH₂⁻), believed to cause "footing" (i. e., a widening of the developed resist feature at its base) of resist material on nitride based ARC materials. The intermediate layer 206 functions as a cap layer for the silicon nitride layer to suppress the formation of any amino basic groups (NH₂⁻), thereby eliminating "footing" of the resist material used in the fabrication sequence.

The intermediate layer 206 is conventionally formed on the silicon nitride layer 204. The intermediate layer 206 should be a material (e. g., silicon dioxide) which has a low reflectivity at DUV wavelengths. Typically, the intermediate layer 206 is deposited to a thickness of about 50 Å to about 200 Å.

Alternatively, the intermediate layer 206 may be formed on the silicon nitride layer 204 using an oxidation reaction. Oxidizing gases such as, for example, oxygen (O₂) and nitrous oxide (N₂O) may be used to form the oxide. In general, the process parameters for such an oxidation reaction range from a wafer temperature of about 200 °C to about 600 °C, a chamber pressure of about 1 torr to about 20 torr, an oxidizing gas flow rate of about 1000 sccm to about 5000 sccm, a radio frequency (RF) power of about 100 watts to about 1000 watts, and a plate spacing of about 300 mils to about 800 mils.

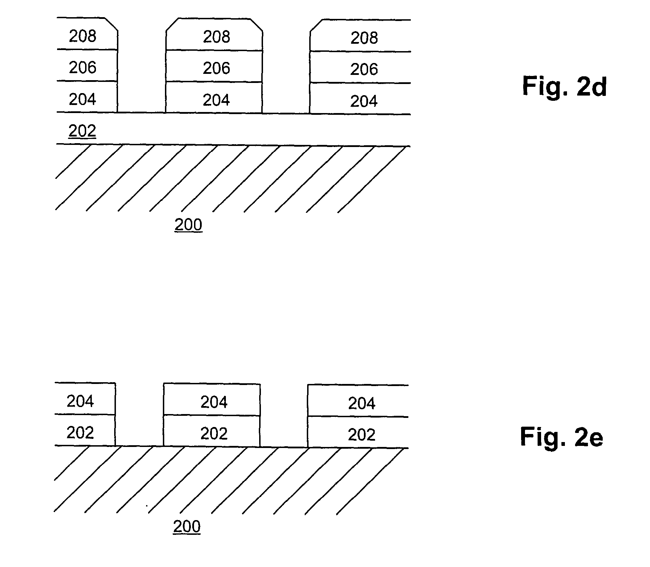

An image of a pattern is introduced into the layer of energy sensitive resist material 208 by exposing such energy sensitive resist material 208 to DUV radiation via mask 210. The image of the pattern introduced into the layer of energy sensitive resist material 208 is developed in an appropriate developer to define the pattern through such layer. Thereafter, referring to FIG. 2c, the pattern defined in the energy sensitive resist material 208 is transferred through the silicon nitride layer 204, as depicted in FIG. 2d. The pattern is transferred through the silicon nitride layer 204 using the energy sensitive resist material 208 as a mask.

The pattern is transferred through the silicon nitride layer 204 by etching it using an appropriate chemical etchant. Fluorocarbon compounds such as trifluoromethane (CHF₃), carbon tetrafluoride (CF₄), chlorotrifluoromethane (CF₃Cl), fluoroethene (C₂F₄), fluoroethane (C₂F₆), or combinations thereof, among others, may be used to transfer the pattern defined in the energy sensitive resist material through the silicon nitride layer.

Alternatively, when the intermediate layer 206 is present, the pattern defined in the energy sensitive resist material 208 is first transferred through the intermediate layer 206 using the energy sensitive material as a mask. Thereafter, the pattern is transferred through the silicon nitride layer 204 using the intermediate layer 206 as a mask. The pattern is transferred through both the intermediate layer 206 as well as the silicon nitride layer 204 using appropriate chemical etchants.

FIG. 2e illustrates the completion of the integrated circuit sequence by the transfer of the pattern defined in the silicon nitride layer 204 through the polysilicon layer 202, using the silicon nitride layer 204 as a hardmask. The pattern is transferred through the polysilicon layer 202 by etching it in an appropriate chemical etchant (e.g., hydrogen bromide (HBr)). Using the silicon nitride ARC layer 204 as a hardmask for an underlying material layer 202, provides fabrication sequence simplification since separate material layers are typically used for an ARC process sequence and a hardmask process sequence.

After the polysilicon layer 202 is patterned, the silicon nitride layer 204 can optionally be stripped from the substrate 200 by etching it in a suitable chemical etchant (e. g., an oxide etching acid such as hydrofluoric acid (HF) and buffered HF). For example, when a subsequent fabrication sequence is a gate fabrication sequence, the ARC layer should be completely removed prior to gate formation.

### B. Damascene Structure Incorporating a Silicon Nitride Layer

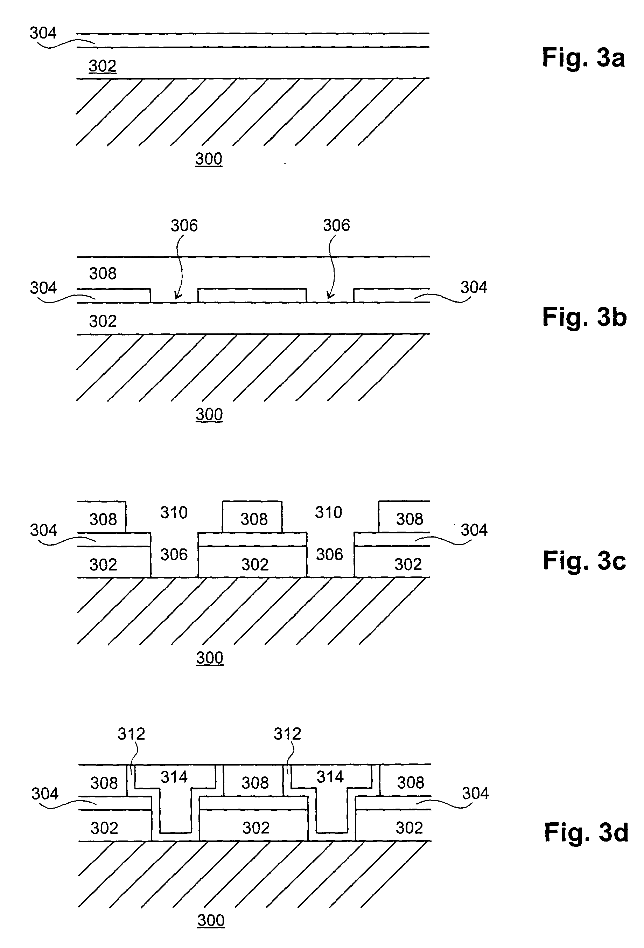

FIGS. 3a-3d illustrate schematic cross-sectional views of a substrate 300 at different stages of a damascene structure fabrication sequence incorporating a silicon nitride layer ARC therein. Damascene structures are typically used to form metal interconnects on integrated circuits. Depending on the specific stage of processing, substrate 300 may correspond to a silicon substrate, or other material layer that has been formed on the substrate 300. FIG. 3a, for example, illustrates a cross-sectional view of a substrate 300 having a first dielectric layer 302 formed thereon. The first dielectric layer 302 may be an oxide (e. g., silicon dioxide, fluorosilicate glass). In general, the substrate 300 may include a layer of silicon, silicides, metals, or other, materials.

FIG. 3a illustrates one embodiment in which the substrate 300 is silicon having a fluorosilicate glass layer formed thereon. The first dielectric layer 302 has a thickness of about 5000 Å to about 10,000 Å, depending on the size of the structure to be fabricated.

A silicon nitride layer 304 is formed on the first dielectric layer 302. The silicon nitride layer 304 is formed on the first dielectric layer 302 according to the process parameters described above. The silicon nitride layer 304 has a refractive index (n) in the range of about 2.0 to about 2.7 and an absorption coefficient (k) in the range of about 0.05 to about 1.0 at wavelengths less than about 250 nm. The refractive index (n) and the absorption coefficient (k) for the silicon nitride layer are tunable, in that they can be varied in the desired range as a function of the process parameters and/or the silicon content of the gas mixture during layer formation.

The silicon nitride layer is an excellent passivation material, making it suitable to minimize capacitive coupling between the metal interconnects to be formed in the damascene structure. Also, the silicon nitride layer is an excellent barrier material, so as to prevent migration of the metal interconnect material (e. g., copper).

The thickness of the silicon nitride layer 304 is variable depending on the specific stage of processing. Typically, the silicon nitride layer 304 has a thickness of about 50 Å to about 1000 Å.

Referring to FIG. 3b, the silicon nitride layer 304 is patterned and etched to define contact/via openings 306 and to expose the first dielectric layer 302, in areas where the contacts/vias are to be formed. The silicon nitride layer is patterned using conventional lithography. More particularly, the silicon nitride layer is patterned using a layer of energy sensitive resist material. The layer of energy sensitive resist material (not shown) is spin coated on the silicon nitride layer to a thickness within the range of about 4000 Å to about 6000 Å. The energy sensitive resist material is sensitive to DUV radiation having a wavelength less than about 250 nm.

An image of a pattern is introduced into the layer of energy sensitive resist material by exposing it to DUV radiation through a mask (not shown). The image of the pattern introduced into the layer of energy sensitive resist material is developed in an appropriate developer to define the pattern through such layer. Thereafter, the pattern defined in the energy sensitive resist material is transferred through the silicon nitride layer. The pattern is transferred through the silicon nitride layer using the energy sensitive resist material as a mask. The pattern is transferred through the silicon nitride layer by etching it in an appropriate etchant. Fluorocarbon compounds such as trifluoromethane (CHF₃), carbon tetrafluoride (CF₄), chlorotrifluoromethane (CF₃Cl), fluoroethene (C₂F₄), fluoroethane (C₂F₆), or combinations thereof, among others, may be used to transfer the pattern defined in the energy sensitive resist material through the silicon nitride layer.

Referring to FIG. 2b, after the silicon nitride layer is patterned, a second dielectric layer 308 is deposited over the silicon nitride layer 304. The second dielectric layer 308 may be an oxide (e. g., silicon dioxide, fluorosilicate glass). The second dielectric layer 308 has a thickness of about 5,000 Å to about 10,000 Å.

The second dielectric layer 308 is then patterned to define interconnect lines 310, as illustrated in FIG. 3c, preferably using conventional lithography processes, as described above for the contacts/vias. The interconnects 310 formed in the second dielectric layer 308 are positioned over the contact/via openings 306 in the silicon nitride layer 304. Thereafter, the contacts/vias 306 are etched using reactive ion etching or other anisotropic etching techniques.

The interconnects 310 and contacts/vias 306 are filled with a conductive material 314 such as copper, aluminum, tungsten, or combinations thereof. Typically, copper is used to fill the interconnects 310 and contacts/vias 306 due to its low resistivity (resistivity about 1.7 µΩ-cm). The conductive material 314 is deposited using chemical vapor deposition, physical vapor deposition, electroplating, or combinations thereof, to form the damascene structure. Preferably, a barrier layer 312 such as tantalum, tantalum nitride, or other suitable barrier material is first deposited conformably on the sidewalls of the interconnects 310 and contacts/vias 306 to prevent metal migration into the surrounding dielectric layers 302, 308.

## Claims

1. A method of forming a device, comprising forming a silicon nitride layer on a substrate and defining a pattern in at least one region of the silicon nitride layer, wherein the pattern is defined in the at least one region of the silicon nitride layer using patterned radiation having a wavelength less than 250 nm.

2. The method of claim 1 further comprising transferring the pattern defined in the at least one region of the silicon nitride layer into the substrate using the silicon nitride layer as a mask.

3. The method of claim 2 comprising removing the silicon nitride layer from the substrate after the pattern has been transferred into the substrate.

4. The method of claim 3 wherein the silicon nitride layer is removed from the substrate by etching it with a fluorine-based compound.

5. The method of claim 4 wherein the fluorine-based compound is selected from hydrofluoric acid (HF) and buffered HF.

6. The method of claim 1 wherein the substrate has one or more material layers formed thereon.

7. The method of claim 6 wherein the one or more material layers formed on the substrate are selected from the group consisting of polysilicon, aluminum (A1), tungsten (W), copper (Cu), titanium (Ti), titanium nitride (TiN), silicon glass, boron doped glass, phosphorous doped glass, tungsten silicide (Wsiₓ), and combination thereof.

8. The method of claim 1 wherein the definition of the pattern in the at least one region of the silicon nitride layer, comprises:
forming a layer of energy sensitive resist material on the silicon nitride layer;
introducing an image of the pattern into the layer of energy sensitive resist material by exposing the energy sensitive resist material to patterned radiation;
developing the image of the pattern introduced into the layer of energy sensitive resist material; and
transferring the pattern developed in the layer of energy sensitive resist material through the silicon nitride layer using the energy sensitive resist material layer as a mask.

9. The method of claim 7 wherein the pattern is transferred through the silicon nitride layer by etching it using a fluorocarbon compound.

10. The method of claim 9 wherein the fluorocarbon compound is selected from trifluoromethane (CHF₃), carbon tetrafluoride (CF₄) , chlorotrifluoromethane (CClF₃), fluoroethene (C₂F4), fluoroethane (C₂F₆), or combinations thereof.

11. The method of claim 8 further comprising forming an intermediate layer on the silicon nitride layer prior to forming the layer of energy sensitive resist material thereon.

12. The method of claim 11 wherein the intermediate layer is an oxide, preferably a silicon dioxide.

13. A method of fabricating a damascene structure, comprising:
forming a first dielectric layer on a substrate;
forming a silicon nitride layer on the first dielectric layer;
patterning the silicon nitride layer to define contacts/vias therethrough, wherein the silicon nitride layer is patterned using radiation having a wavelength less than 250 nm;
forming a second dielectric layer on the patterned silicon nitride layer;
patterning the second dielectric layer to define interconnects therethrough, wherein the interconnects are positioned over the contacts/vias defined in the silicon nitride layer;
etching the first dielectric layer to form contacts/vias therethrough; and
filling the contacts/vias and the interconnects with a conductive material.

14. The method of claim 12 wherein the first dielectric layer and the second dielectric layer are each selected from the group consisting of amorphous carbon, fluorinated amorphous carbon, parylene, fluorinated silicate glass (FSG), AF4, BCB, silicon carbide, oxynitride, and combinations thereof.

15. The method of claim 12 wherein the conductive material filling the contacts/vias and interconnects is selected from the group consisting of copper, aluminum, tungsten, and combinations thereof.

16. The method of claim 1 or 12 wherein the silicon nitride layer is formed on the substrate by
positioning the substrate in a deposition chamber;
providing a gas mixture to the deposition chamber, wherein the gas mixture comprises a silicon containing compound and a nitrogen containing compound; and
reacting the gas mixture in the deposition chamber to form the silicon nitride layer on the substrate.

17. The method of claim 16 wherein the silicon containing compound has the general formula SiₓHy, wherein x has a range of 1 to 4 and y has a range of 1 to 10.

18. The method of claim 17 wherein the silicon containing compound is selected from the group consisting of silane (SiH₄), disilane (Si₂H₆), trisilane (Si₃H₈), tetrasilane (Si₄H₁₀), dichlorosilane (SiCl₂H₂), or combinations thereof.

19. The method of claim 16 wherein the nitrogen containing compound is selected from the group of nitrogen (N₂), ammonia (NH₃), or combinations thereof.

20. The method of claim 16 wherein the gas mixture further comprises an additive gas.

21. The method of claim 20 wherein the additive gas is selected from the group consisting of argon (Ar), nitrogen (N₂), helium (He), or combinations thereof.

22. The method of claim 16 wherein the deposition chamber is maintained at a temperature between 200°C to 600°C.

23. The method of claim 16 wherein the deposition chamber is maintained at a pressure in a range of 1 Torr to 20 Torr.

24. The method of claim 16 wherein the silicon containing compound is provided to the deposition chamber at a flow rate in a range of 50 sccm to 500 sccm.

25. The method of claim 16 wherein the nitrogen containing compound is provided to the deposition chamber at a flow rate in a range of 10 sccm to 300 sccm.

26. The method of claim 20 wherein the additive gas is provided to the deposition chamber at a flow rate of 1000 sccm to 5000 sccm.

27. The method of claim 16 wherein the silicon containing compound reacts with the nitrogen containing compound in the presence of an electric field.

28. The method of claim 27 wherein the electric field is a radio frequency (RF) power.

29. The method of claim 28 wherein the RF power is within a range of 100 watts to 1000 watts.

30. The method of claim 16 wherein the silicon nitride layer has an absorption coefficient in the range of 0.05 to 1.0 at wavelengths less than 250 nm.
